# EUROPÄISCHE PATENTSCHRIFT

(11) **EP 2 552 586 B1**
(45) Veröffentlichungstag und Bekanntmachung des Hinweises auf die Patenterteilung: **29.07.2020**
(21) Anmeldenummer: 11709899.6
(22) Anmeldetag: 10.03.2011
(51) Int. Cl.: B01L 3/00

(54) **BAUTEIL EINES BIOSENSORS UND VERFAHREN ZUR HERSTELLUNG**
COMPONENT OF A BIOSENSOR AND METHOD FOR PRODUCING SAME
COMPOSANT D'UN BIOCAPTEUR ET SON PROCÉDÉ DE FABRICATION

(30) Priorität: 31.03.2010 EP 10158661
(43) Veröffentlichungstag der Anmeldung: 06.02.2013
(73) Patentinhaber: Boehringer Ingelheim Microparts GmbH, 44227 Dortmund (DE)
(72) Erfinder: SCHOEN, Christian, 55216 Ingelheim am Rhein (DE); WAGENER, Michael, 55216 Ingelheim am Rhein (DE)
(74) Vertreter: Hammann, Heinz
(86) Internationale Anmeldenummer: PCT/EP2011/053573
(87) Internationale Veröffentlichungsnummer: WO 2011/120773

(56) Entgegenhaltungen:
- EP-A1- 1 426 108
- EP-A1- 1 441 131
- EP-A1- 1 925 365
- WO-A1-2010/012281
- US-A- 5 958 345
- US-A1- 2007 161 928
- US-A1- 2008 176 398
- US-A1- 2009 053 106
- US-A1- 2010 075 422

## Beschreibung

Die Erfindung betrifft ein Verfahren zur Herstellung eines Bauteil eines Biosensors, mit wenigstens einer ersten Einrichtung zur Aufnahme einer Probenflüssigkeit, wobei die Einrichtung über einen Verteilerkanal mit weiteren Aufnahmeeinrichtungen verbunden ist, in die jeweils ein vom Verteilerkanal abzweigender Zulaufkanal mündet und die Zulaufkanäle in Strömungsrichtung der durch den Verteilerkanal weitergeleiteten Probenflüssigkeit aufeinander folgend angeordnet sind.

In der modernen medizinischen Diagnostik wird eine immer größere Anzahl von Biosensoren, unter die auch so genannte Diagnoseteststreifen subsumiert werden sollen, verwendet. Mit Hilfe von Biosensoren können beispielsweise biologische Flüssigkeiten (z. B. Blut, Urin oder Speichel) zum einen auf Krankheitserreger, Unverträglichkeiten und zum anderen aber auch auf Gehalt beispielsweise an Glukose (Blutzucker) oder Cholesterol (Blutfett) untersucht werden.

Dazu finden auf den Biosensoren Nachweisreaktionen oder ganze Reaktionskaskaden statt. Hierfür ist es erforderlich, dass die biologische Probenflüssigkeit (Testflüssigkeit) zu dem dafür vorgesehenen Reaktionsort bzw. den Reaktionsorten transportiert wird. Biosensoren bestehen daher zumindest aus einem Mikrokanal bzw. aus einem Mikrokanalsystem, wo hindurch die Probenflüssigkeit transportiert wird. Mikrokanäle weisen dabei typischerweise eine Höhe und Breite von ca. 5 bis 1500 Mikrometer auf. Zur gezielten Bewegung (Transport) der Probenflüssigkeit können verschiedene Methoden, wie Elektrokinetik, Druck oder Kapillarität verwendet werden. Diese Methoden können einzeln aber auch durchaus kombiniert angewendet werden. Bei der Elektrokinetik wird der elektrokinetische Fluss dabei durch das Anlegen elektrischer Spannung an die Kanäle erreicht. Die dabei auftretenden Phänomene (Elektroosmose und Elektrophorese) führen zur Bewegung von geladenen Molekülen. Beim Anlegen von Drücken, beispielsweise durch Mikropumpen, können auch ungeladene Moleküle bewegt werden.

In der EP 1426108 wird eine Vorrichtung zur parallelen Dosierung von Flüssigkeiten beschrieben, wobei die Vorrichtung einen Hauptkanal mit einer Vielzahl von davon abgehenden Nebenkanälen, ein Mittel zur Übertragung von (beispielsweise mechanisch oder elektromechanisch erzeugten) Druckstößen eines Druckmediums von einer ersten Kammer zu den Nebenkanälen aufweist. Die Nebenkanäle sind dabei drucktechnisch voneinander entkoppelt.

Neben den beiden so genannten aktiven Methoden (Elektrokinetik und Anlegen von Drücken) hat aber auch die so genannte passive Bewegung große Bedeutung. Hierbei werden allein durch Ausnutzung der Kapillarkraft die Probeflüssigkeiten gezielt bewegt. Vorteilhaft an dieser Technik ist es, dass sie ohne weitere Antriebsmechanismen auskommt und damit eine Vereinfachung des Gesamtsystems ermöglicht.

In der US 2009/0053106 wird eine "autonomer" mikrofluidische Vorrichtung beschrieben, die im Wesentlichen durch ein Substrat mit einer Mikrokanalstruktur gebildet wird. Auf diesem Substrat bewirken Gravitation, Adhäsionskräfte und Oberflächenspannung die Strömung eines eingebrachten Fluids durch einen Hauptkanal in eine Vielzahl stromabwärts angeordneter Verteilerkanäle, die sich in Abhängigkeit des jeweils für die einzelnen abgezweigten Fluidmengen in der Vorrichtung vorgesehenen biologischen Test in Länge, Breite und Tiefe unterscheiden.

In der EP 1441131 wird zum Einsatz in mikrofluidischen Analyse-Anordnungen ein mikrofluidischer Schalter zum Anhalten eines Flüssigkeitsstroms während eines Zeitintervalls beschrieben. Der Schalter weist einen ersten Kanal auf, in dessen Endbereich sich ein Mittel (hier ein geometrisch gestalteter Kapillarstop) zum Anhalten eines im ersten Kanal fließenden Flüssigkeitsstroms befindet. Durch Ansteuerung dieses Mittels durch einen in einem zweiten Kanal mit gleichem Endbereich fließenden Flüssigkeitsstrom kann der Flüssigkeitsstrom aus dem ersten Kanal wieder gestartet werden.

In der US 2007/0161928 A1 wird eine Vorrichtung beschrieben, die zur Probennahme von Flüssigkeiten im Verdauungstrakt von der Testperson geschluckt werden soll. Die Vorrichtung weist eine innenliegende Struktur mit einem Kanal (abgehend von einer Einlassöffnung) und optional davon abgehenden Näpfen auf. In dem Kanal sind hydrophobe Barrieren derart angebracht, dass sich erst ein seitlich vom Hauptkanal angeordneter Napf befüllt, bevor die Flüssigkeit weiter den Hauptkanal entlang fließt. Die Kanalstrukturen (inklusiver der Näpfe) werden beispielsweise durch nasse oder trockene chemische Ätzverfahren in Silizium hergestellt und die hydrophoben Barrieren in einen weiteren Prozessen durch Bereiche aus so genanntem "schwarzen Silizium" gebildet.

Die moderne Entwicklung der Biosensoren zielt auf eine Verkürzung der Messzeit zwischen Aufgabe der Probenflüssigkeit auf dem Biosensor und dem Erscheinen des Messwertes ab. Diese Messzeit, d. h. die Zeit zwischen Aufgabe der Probenflüssigkeit auf dem Biosensor bis zur Anzeige des Messwertes ist neben der eigentlichen Reaktionszeit der verwendeten Reagenzien mit der Probenflüssigkeit und eventueller Folgereaktionen auch davon abhängig, wie schnell die Probenflüssigkeit innerhalb des Biosensors von der Aufgabestelle der Probenflüssigkeit zum Reaktionsort transportiert wird. Ein schneller Flüssigkeitstransport wird zumeist über eine hydrophile Beschichtung der Kanäle gewährleistet.

Des Weiteren geht der Trend zu der Entwicklung von Biosensoren mit immer geringeren Flüssigkeitsvolumen, um dadurch beispielsweise bei Diabetespatienten die Schmerzen bei der Blutentnahme zu verringern. Aufgrund der Begrenztheit der Probenflüssigkeit ist es daher umso wichtiger, dass dennoch ausreichend Probenflüssigkeit zu den Reaktionsorten gebracht wird, damit eine einwandfreie Reaktion der in den Reaktionsorten befindlichen Reagenzien mit der Probenflüssigkeit gewährleistet ist. In der Regel sind die Reaktionsorte eines Biosensors kammerartig ausgebildete Einrichtungen zur Aufnahme der Probenflüssigkeit (Reaktionskammern).

Aus der WO 99/46045 ist ein Biosensor (Probenträger) mit einer Einrichtung zur Aufnahme einer Probenflüssigkeit bekannt, wobei die Einrichtung über einen Verteilerkanal und davon abgehenden, aufeinanderfolgend angeordneten Zulaufkanälen mit Reaktionskammern verbunden ist. Dieser Biosensor benutzt zum Transport von Probenflüssigkeit lediglich Kapillarkräfte. Zur Erzeugung von Kapillarkräften und zur optimalen Befüllung der in dem Biosensor vorgesehenen Reaktionskammern sind in jeder Reaktionskammer im Einmündungsbereich des jeweiligen Zulaufkanals spezielle Einrichtungen zur Erzeugung einer Kapillarkraft zum Fließen der Probenflüssigkeit aus dem Zulaufkanal in die jeweilige Reaktionskammer vorgesehen. Bei der Verteilung der Probenflüssigkeit über die vorgesehenen Verteilerkanäle und die von diesen jeweils abzweigenden Zulaufkanälen wird dort angestrebt, dass die Probenflüssigkeit möglichst gleichmäßig und insbesondere gleichzeitig sämtliche Reaktionskammern füllt.

Die Anmelderin hat jedoch festgestellt, dass es auch wünschenswert sein kann (insbesondere wenn nur wenig Probenflüssigkeit zur Verfügung steht), dass die Reaktionskammern nicht gleichzeitig, sondern nacheinander (sequentiell) befüllt werden.

Der vorliegenden Erfindung liegt die Aufgabe zugrunde, ein Bauteil eines Biosensors bereitzustellen, durch welches ein im wesentlichen sequentielles Befüllen von im Biosensor vorhandenen Aufnahmeeinrichtungen für Probenflüssigkeit, insbesondere Reagenzien enthaltenden Reaktionskammern, ermöglicht wird.

Diese Aufgabe wird mittels eines Herstellverfahrens gemäß Patentanspruch 1 gelöst. Die Unteransprüche enthalten vorteilhafte Ausgestaltungen des erfinderischen Verfahrens zur Herstellung eines Bauteils eines Biosensors.

Die Erfindung geht aus von einem Bauteil eines Biosensors, mit wenigstens einer ersten Einrichtung zur Aufnahme einer Probenflüssigkeit, wobei die erste Aufnahmeeinrichtung über einen Verteilerkanal mit weiteren Aufnahmeeinrichtungen verbunden ist, in die jeweils ein vom Verteilerkanal abzweigender Zulaufkanal mündet und die Zulaufkanäle in Strömungsrichtung der durch den Verteilerkanal weitergeleiteten Probenflüssigkeit aufeinander folgend angeordnet sind.

Erfindungsgemäß ist vorgesehen, dass im Verteilerkanal jeweils zwischen zwei in Strömungsrichtung unmittelbar aufeinander folgenden Zulaufkanälen wenigstens ein Bereich zum zumindest zeitweisen Verlangsamen oder Stoppen des kapillaren Flusses der Probenflüssigkeit eingebracht wird.

Durch diese Maßnahme ist es möglich, den kapillaren Fluss der Probenflüssigkeit im Verteilerkanal derart zu steuern, dass zunächst eine erste mit Probenflüssigkeit zu füllende Aufnahmeeinrichtung, die beispielsweise bestimmte Reagenzien enthalten kann, vollständig bzw. soweit gefüllt wird, so dass darin bspw. eine gute Auflösung von Reagenzien und damit eine einwandfreie Reaktion der Reagenzien mit der Probenflüssigkeit stattfinden kann. Erst danach erreicht die (temporär verlangsamte) Probenflüssigkeit die in Strömungsrichtung liegende nächste Aufnahmeeinrichtung bzw. nimmt (im Falle eines temporären Stopps) ihre Bewegung zur nächsten Aufnahmeeinrichtung wieder auf. Die Wiederaufnahme der Bewegung kann dabei automatisch (beispielsweise aufgrund hydrostatischen Drucks) oder auch von außen gesteuert (beispielsweise durch Anlegen eines externen Druckes) initiiert werden. Somit ist sichergestellt, dass jede bspw. als Reaktionskammer ausgebildete Aufnahmeeinrichtung zunächst weitmöglichst und schnell mit Probenflüssigkeit befüllt wird, bevor die Probenflüssigkeit weiter zur (in Strömungsrichtung liegenden) nächsten Aufnahmeeinrichtung fließt bzw. diese erreicht und dort gleichermaßen eine Befüllung stattfinden kann. Der Vorgang kann sooft wiederholt werden, wie mit der Probenflüssigkeit zu befüllende Aufnahmeeinrichtungen vorgesehen sind.

Erfindungsgemäß ist vorgesehen, dass der wenigstens eine Bereich zum zumindest zeitweisen Verlangsamen oder Stoppen des Kapillarflusses der Probenflüssigkeit durch wenigstens eine im Verteilerkanal vorhandene, hydrophobe Oberfläche gebildet ist. Der Verteilerkanal, der ansonsten zur Beschleunigung des kapillaren Flusses hydrophil ausgebildet ist, wird also in diesem Bereich gezielt hydrophob ausgestaltet. Die hydrophobe Oberfläche des Verteilerkanals in diesem Bereich wird dabei (anstelle durch eine hydrophobe Beschichtung) durch eine Abtragung einer in diesem Bereich vorgesehenen hydrophilen Beschichtung mittels eines gepulst betriebenen Lasers erfolgen, was Sinn macht, wenn der darunter liegende Grundwerkstoff des Verteilerkanals aus Material besteht, welches weniger hydrophile Eigenschaften aufweist, als die Beschichtung selbst. Dies ist beispielsweise bei Polystyrol, Polypropylen, Polycarbonat oder PMMA der Fall.

Dabei kann es durchaus vorteilhaft sein, wenn der wenigstens eine Bereich zum zumindest zeitweisen Verlangsamen oder Stoppen des kapillaren Flusses der Probenflüssigkeit eine Querschnittserweiterung des Verteilerkanals bildet. Eine solche Querschnittserweiterung des Verteilerkanals kann den gewollten Effekt in diesem Bereich noch verstärken. Eine solche zusätzliche Querschnittserweiterung würde beispielsweise dann auftreten, wenn in diesem Bereich eine hydrophile Beschichtung des Verteilerkanals entfernt wird. Die Querschnittserweiterung des Verteilerkanals würde dabei zumindest dem Betrag der Dicke der entfernten hydrophilen Schicht entsprechen.

Alternativ ist es aber auch denkbar und durchaus zweckmäßig, wenn der wenigstens eine Bereich zum zumindest zeitweisen Verlangsamen oder Stoppen des kapillaren Flusses der Probenflüssigkeit durch im Verteilerkanal eingebrachte und in Strömungsrichtung der Probenflüssigkeit sich jeweils abwechselnde Querschnittsverengungen und Querschnittserweiterungen gebildet ist. Wenn das Bauteil aus Kunststoff hergestellt ist, so können derartige Querschnittsverengungen und Querschnittserweiterungen mit den im Spritzgussverfahren üblichen Abformtechniken hergestellt werden.

Es kann zweckmäßig sein, wenn das Bauteil mehr als zwei weitere Kammern, insbesondere vier aufweist. Hierdurch wird es ermöglicht, mit einem einzigen Biosensor mehrere Nachweisreaktionen durchführen zu lassen.

Ein Biosensor mit einem gemäß Ausführungsbeispiel ausgestalteten Bauteil führt zu schnelleren und genaueren Messergebnissen.

Die Erfindung betrifft ein Verfahren zur Herstellung eines Bereiches zum zumindest zeitweisen Verlangsamen oder Stoppen des kapillaren Flusses einer Probenflüssigkeit in einem Kanal eines Biosensors.

Üblicherweise wird ein Verlangsamen oder Stoppen des kapillaren Flusses einer Probenflüssigkeit in einem Kanal (Kapillarstopp) durch schlagartige Erweiterung des Kanals in eine oder beide Richtungen, die senkrecht zur Befüllrichtung des Kanals (bzw. zur Strömungsrichtung der Probenflüssigkeit) liegen, bewerkstelligt. Durch die schlagartige Vergrößerung des Querschnitts verringern sich ebenso schlagartig die Kapillarkräfte, die den Meniskus einer Flüssigkeitsfront der Probenflüssigkeit entlang des Kanals bewegen. Die Fließgeschwindigkeit der Flüssigkeit verringert sich daher drastisch, gegebenenfalls bis auf Null. Die Erzeugung eines solchen (geometrisch erzeugten) Kapillarstopps mittels herkömmlicher Abformtechnik ist insofern aufwändig, als für die Erzeugung der notwendigen scharfen Kanten im Abformteil eine aufwändige Bearbeitung des Formeinsatzes notwendig ist und durch die damit einhergehenden hohen Kosten eine Wirtschaftlichkeit erst bei sehr hohen Stückzahlen erreicht werden kann.

Der Erfindung liegt daher auch die Aufgabe zugrunde, ein Verfahren zur Herstellung eines Bereichs zum zumindest zeitweisen Verlangsamen oder Stoppen des kapillaren Flusses einer Probenflüssigkeit in einem Kanal eines Biosensors bereitzustellen, welches einfach und wirtschaftlich ist.

Erfindungsgemäß weist dieses Verfahren folgende Verfahrensschritte auf:
- zumindest bereichsweise Hydrophilisierung des Kanals mit einer hydrophilen Schicht
- zumindest bereichsweise Entfernung der hydrophilen Schicht mittels eines gepulst betriebenen Lasers.

Durch die zumindest bereichsweise Hydrophilisierung des Kanals mit einer hydrophilen Schicht und die anschließend zumindest bereichsweise Entfernung der hydrophilen Schicht ist insgesamt eine einfache und auch bei niedrigeren Stückzahlen wirtschaftliche Herstellung möglich. Zudem lassen sich die hydrophile Beschichtung des Kanals und auch die Entfernung der hydrophilen Schicht mittels unterschiedlicher Methoden vergleichsweise einfach bewerkstelligen.

Beispielsweise ist es sehr vorteilhaft, die hydrophile Schicht aufzusprühen. Dies kann beispielsweise unter Verwendung einer Maske erfolgen, so dass gezielt nur bestimmte Bereiche hydrophilisiert werden. Das Aufsprühen erlaubt eine großflächige Hydrophilisierung und einen guten Einsatz in der Massenfertigung.

Das bereichsweise Entfernen der hydrophilen Schicht wird erfindungsgemäß sehr vorteilhaft mittels eines Lasers bewerkstelligt. Dabei bietet sich vorteilhaft auch die Verwendung einer entsprechenden Maske an, da so trotz Bestrahlung größerer Bereiche mittels Laserstrahlung dennoch eine gezielte Schichtabtragung ermöglicht wird.

Eine sehr genaue Bearbeitung bzw. Schichtabtragung ist dann möglich, wenn die hydrophile Schicht ablatiert wird. Hierbei geht das zu entfernende Material vom festen Zustand unmittelbar in den dampfförmigen Zustand über, wodurch Verunreinigungen bzw. Geometrieungenauigkeiten durch entferntes Material vermieden werden. Nicht der Laserstrahlung ausgesetzte Bereiche werden nicht verändert. Als Laser bietet sich hier insbesondere ein Excimer-Laser an. Derartige Laser erzeugen elektromagnetische Strahlung im ultravioletten Wellenlängenbereich (beispielsweise 248 Nanometer) und können nur gepulst betrieben werden. Die dabei erreichbaren, hohen Pulsenergien von bis zu 300 Millijoule ermöglichen eine gute Ablation.

Weiterhin ist es sehr leicht möglich, die gewünschte Stärke des Kapillarstopps bzw. das Maß der gewünschten Verlangsamung der Probenflüssigkeit (und damit letztendlich den Grad der sequentiellen Befüllung) über Verfahrensparameter einzustellen. Geeignete Parameter sind beispielsweise die Anzahl der auftreffenden Laserpulse pro bearbeitetem Bereich (Laserenergie) und/oder die Position des bearbeiteten Bereiches zwischen jeweils zwei aufeinander folgenden Aufnahmeeinrichtungen in Strömungsrichtung gesehen. Letztere ist zB durch die Wahl einer entsprechenden Maske beeinflussbar. Es hat sich in Versuchen gezeigt, dass die Position eines solchen Bereichs zum temporären Verlangsamen oder Stoppen des kapillaren Flusses in Strömungsrichtung gesehen jeweils vorzugsweise innerhalb der ersten Hälfte des Abstandes, insbesondere innerhalb des ersten Drittels des Abstandes von direkt aufeinanderfolgenden Zulaufkanälen vorzusehen ist. Dies führte vergleichsweise zu einer besonders guten sequentiellen Befüllung der hintereinander angeordneten Aufnahmeeinrichtungen.

Des Weiteren ist es natürlich auch möglich und durchaus vorteilhaft, den Verteilerkanal aus einem Werkstoff zu wählen, der für die Wellenlänge des verwendeten Lasers empfindlich ist. In diesem Fall könnte auch der unter der hydrophilen Schicht vorhandene Werkstoff (bspw. Polycarbonat) nennenswert abgetragen bzw. ablatiert werden, was die gewollte Wirkung in dem bearbeiteten Bereich verstärken würde, da eine zusätzliche Querschnittserweiterung des Kanals dadurch erfolgt.

Weitere Vorteile und Ausgestaltungen der Erfindung werden anhand von Ausführungsbeispielen deutlich, was mit Hilfe der beiliegenden Figuren näher erläutert werden soll. Dabei bedeuten
- Fig. 1: eine äußerst prinziphafte Darstellung eines aus mehreren Bauteilen zusammengesetzten Biosensors im Längsschnitt,
- Fig. 2: ein vereinfacht dargestelltes Bauteil des Biosensors gemäß Ansicht II in Fig.1, welches gemäß der Erfindung ausgeführt ist und wobei die darüber liegenden Bauteile der Verständlichkeit halber weggelassen sind,
- Fig. 3: einen vergrößert dargestellten Ausschnitt gemäß Einzelheit III aus Fig. 2, und zwar als a) bevorzugtes Ausführungsbeispiel und b) weiteres Ausführungsbeispiel,
- Fig. 4: eine prinziphafte Darstellung des erfindungsgemäßen Verfahrens zur Herstellung eines Bereiches zum zumindest zeitweisen Verlangsamen oder Stoppen des kapillaren Flusses einer Probenflüssigkeit im Kanal eines Biosensors gemäß Schnittverlauf IV aus Fig. 3a.

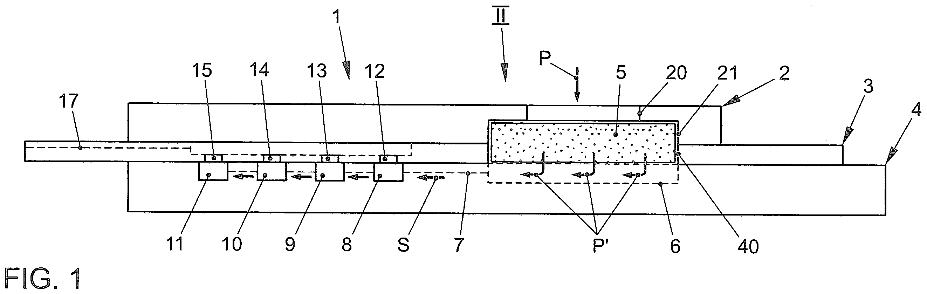

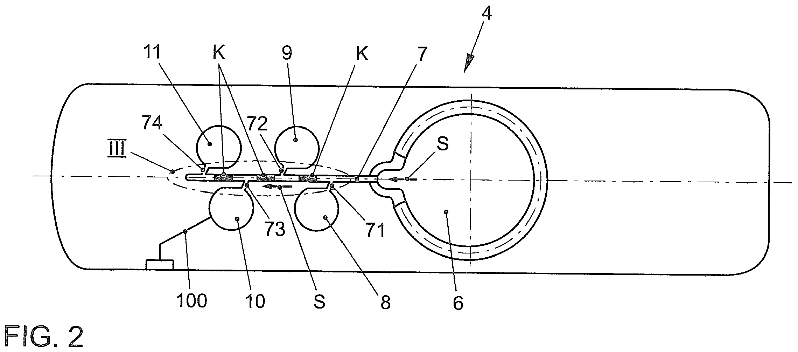

Fig. 1 zeigt äußerst prinziphaft die seitliche (Schnitt)Ansicht für ein mögliches Ausführungsbeispiel eines Biosensors 1, welcher ein erfindungsgemäß hergestelltes Bauteil 4 enthält. Der Biosensor 1 ist im Wesentlichen aus drei flachen, im Grundriss in etwa rechteckigen Bauteilen 2, 3 und 4 aus Kunststoff (beispielsweise Polycarbonat oder Polystyrol) zusammengesetzt, wobei die Bauteile 2,3 und 4 jeweils miteinander verklebt sind. Zumindest das Bauteil 4 ist im Spritzgussverfahren hergestellt. Das obere Bauteil 2 weist eine Öffnung 20 zur Aufgabe einer Probenflüssigkeit P (beispielsweise Blut) auf. In die Öffnung 20 kann dazu die geöffnete Fingerbeere eines Patienten hineingelegt werden. Unterhalb der Öffnung 20 ist eine Vertiefung 21 zur teilweisen Aufnahme eines Filters 5 vorgesehen. Das zweite Bauteil 3 weist ebenfalls eine unterhalb der Vertiefung 21 liegende Öffnung 40 auf, in die der Filter 5 hineinragen kann. Der Filter 5 dient zur Filtrierung der Probenflüssigkeit P, wobei unten aus dem Filter eine filtrierte Probenflüssigkeit P' (beispielsweise Blutplasma aus Vollblut) erzeugt wird. Zur Aufnahme der filtrierten Probenflüssigkeit P' weist das dritte Bauteil 4 eine erste Aufnahmeeinrichtung 6 auf. Die Aufnahmeeinrichtung 6 dient nicht nur zur Aufnahme und zum "Heraussaugen" der filtrierten Probenflüssigkeit P' aus dem Filter 5 sondern auch zur Weiterleitung der filtrierten Probenflüssigkeit P' hin zu einem Verteilerkanal 7 (vgl. Pfeile). Der Verteilerkanal 7 ist Teil eines Kanalsystems, welches die filtrierte Probenflüssigkeit P' fluidisch mit weiteren Aufnahmeeinrichtungen 8 bis 11 des dritten Bauteils 4 verbindet (vergleiche auch Fig. 2). Die weiteren Aufnahmeeinrichtungen 8 bis 11 sind napfförmig ausgestaltet, wobei die gefilterte Probenflüssigkeit P' im Verteilerkanal 7 eine Strömungsrichtung S vollführt, in Bezug zu der die Aufnahmeeinrichtung 8 am Anfang und die Aufnahmeeinrichtung 11 am Ende liegt.

Des Weiteren ist ersichtlich, dass das zweite Bauteil 3 ebenfalls Aufnahmeeinrichtungen 12 bis 15 für die filtrierte Probenflüssigkeit P' aufweist. Die Aufnahmeeinrichtungen 12 bis 15 sind dabei ebenfalls napfförmig ausgestaltet und in etwa konzentrisch zu den ihnen zugeordneten Aufnahmeeinrichtungen 8 bis 11 des dritten Bauteils 4 angeordnet. Zwischen den Aufnahmeeinrichtungen 8 bis 11 einerseits und den Aufnahmeeinrichtungen 12 bis 15 andererseits besteht ein nicht näher dargestellter fluidischer Verbindungsweg, so dass die paarweise zugeordneten Aufnahmeeinrichtungen (beispielsweise 8 und 12) eine Art Kammer bilden. Die Aufnahmeeinrichtungen 12 bis 15 sind mit einem angedeuteten Elektrodensystem 17 verbunden. Ferner sind in den Aufnahmeeinrichtungen 12 bis 15 getrocknete Reagenzien eingebracht, welche nach Auflösung durch die filtrierte Probenflüssigkeit P' jeweils eine elektrochemische Reaktion auslösen. Das Ergebnis dieser Reaktion ist jeweils charakteristisch für die zu bestimmenden Analyten. Zum messbaren Abgriff dieser elektrochemischen Reaktionen ist das Elektronensystem 17 vorgesehen.

In Fig. 2 ist nun das Bauteil 4 einzeln in einer Draufsicht gemäß Ansicht II aus Fig. 1 dargestellt. Auch in dieser Figur ist das Bauteil lediglich vereinfacht dargestellt und zeigt nur die zum Verständnis der Erfindung wichtigsten Strukturen. Das Bauteil 4 weist in etwa eine Länge von 40 mm, eine Breite von 10 mm und ein Höhe von 1,5 mm auf. Es ist die Aufnahmeeinrichtung 6 ersichtlich, die sich innerhalb einer Vertiefung des Bauteils 4 befindet und welche, wie bereits erläutert, zur Aufnahme und anschließenden Weiterleitung der filtrierten Probenflüssigkeit P' dient. Die durch die Aufnahmeeinrichtung 6 aufgenommene Probenflüssigkeit P' wird zu dem Verteilerkanal 7 weitergeleitet. In dieser Ansicht ist ersichtlich, dass die Aufnahmeeinrichtungen 8 bis 11 beidseitig des Verteilerkanals 7 angeordnet sind, wobei die Aufnahmeeinrichtungen 9 und 11 auf der einen Seite, die Aufnahmeeinrichtungen 8 und 10 auf der anderen Seite liegen. Um eine Befüllung der Aufnahmeeinrichtungen 8 bis 11 mit Probenflüssigkeit P' zu ermöglichen, ist der Verteilerkanal 7 mit den Aufnahmeeinrichtungen 8 bis 11 jeweils über einen Zulaufkanal (vergleiche 71 bis 74) verbunden. In Strömungsrichtung S der Probenflüssigkeit P' gesehen liegen die Zulaufkanäle 71 bis 74 hintereinander, wobei zunächst von der Probenflüssigkeit P' der Zulaufkanal 71, dann der Zulaufkanal 72, anschließend der Zulaufkanal 73 und zum Schluss der Zulaufkanal 74 erreicht wird.

Zur besseren (schnelleren) kapillaren Weiterleitung der Probenflüssigkeit P' ist die Oberfläche des Bauteils 4 zumindest im Bereich des Verteilerkanals 7 und der Zulaufkanäle 71 bis 74 hydrophilisiert bzw. mit einer hydrophilen Schicht versehen. Zusätzlich sind in den Verteilerkanal 7 jedoch noch mehrere Bereiche K eingebracht, welche zum zumindest zeitweisen Verlangsamen oder Stoppen des kapillaren Flusses der filtrierten Probenflüssigkeit P' dienen sollen, was später noch genauer erläutert wird. Wie ersichtlich, ist im Verteilerkanal 7 jeweils zwischen zwei in Strömungsrichtung S unmittelbar aufeinander folgenden Zulaufkanälen (also zwischen den Zulaufkanälen 71 und 72 bzw. 72 und 73 bzw. 73 und 74) jeweils ein Bereich K eingebracht. Die Ausgestaltung oder gar Anzahl der zwischen zwei unmittelbar aufeinanderfolgenden Zulaufkanälen eingebrachten Bereiche K ist abhängig von der jeweils erforderlichen bzw. gewünschten Verzögerung des kapillaren Flusses. Die Einbringung der Bereiche K hat nun folgende Bewandtnis:
Die in den Aufnahmeeinrichtungen 12 bis 15 befindlichen Reagenzien können nur dann optimal (ohne Klümpchenbildung) aufgelöst werden, wenn diese schnell und vollständig mit der gefilterten Probenlösung P' benetzt werden. Dies ist nur dann möglich, wenn auch die jeweils den Aufnahmeeinrichtungen 12 bis 15 zugeordneten Aufnahmeeinrichtungen 8 bis 11 des Bauteils 4 jeweils schnell mit Probenflüssigkeit P' vollkommen ausgefüllt werden und aufgrund der fluidischen Verbindung zwischen den Aufnahmeeinrichtungen 8 bis 11 mit jeweils den diesen zugeordneten Aufnahmeeinrichtungen 12 bis 15 ein schneller Anstieg des Flüssigkeitspegels auch in den die Reagenzien enthaltenen Aufnahmeeinrichtungen 12 bis 15 erfolgt. Zu beachten ist dabei, dass nur sehr begrenzt gefilterte Probenflüssigkeit P' zur Verfügung steht. Das rührt zum einen daher, dass nur eine geringe Menge Probenflüssigkeit P (in der Regel nur ca. 20 □l, z. B. Vollblut) aufgegeben wird und zum andern daher, dass aufgrund einer Verringerung des Volumenstroms im Filter nach kurzer Zeit immer weniger gefilterte Probenflüssigkeit P' "hinten" ankommt. Daher müssen die Aufnahmeeinrichtungen 8 bis 11 bzw. 12 bis 15 so schnell wie möglich jeweils gut befüllt werden.

Ohne die Einbringung der vorgenannten Bereiche K würde aufgrund der hydrophilen Beschichtung des Verteilerkanals 7 und der Zulaufkanäle 71 bis 74 der Volumenstrom der filtrierten Probenflüssigkeit P' nahezu gleichzeitig alle Zulaufkanäle 71 bis 74 erreichen und auch quasi gleichzeitig alle Aufnahmeeinrichtungen 8 bis 11 bzw. 12 bis 15 befüllen. Diese Aufteilung des Volumenstroms würde jedoch dazu führen, dass die Befüllung der einzelnen Aufnahmeeinrichtungen 8 bis 11 bzw. 12 bis 15 länger dauern würde, bzw. nicht optimal verlaufen könnte, was unerwünscht ist. Durch die Einbringung der Bereiche K dringt die Probenflüssigkeit P' nun zunächst ungehindert durch den hydrophilisierten Verteilerkanal 7 und in den Zulaufkanal 71 hindurch und kann die erste Aufnahmeeinrichtung 8 sowie die dieser zugeordneten Aufnahmeeinrichtung 12 schnell befüllen. Dabei steht für das Befüllen der gesamte Volumenstrom der Probenflüssigkeit P' zur Verfügung, da diese bei Erreichen des Bereichs K gestoppt wird bzw. zumindest so verlangsamt wird, dass bis zum Erreichen des darauf folgenden Zulaufkanals 72 für die Probenflüssigkeit P' ausreichend Zeit verbleibt, die erste Aufnahmeeinrichtung 8 sowie die dieser zugeordneten Aufnahmeeinrichtung 12 vollständig zu befüllen. Auch bei einem vollständigen Kapillarstopp der Probenflüssigkeit P' im Bereich K würde der kapillare Fluss nach einer bestimmten kurzen Zeit aufgrund verschiedener Faktoren (unter anderem hydrostatischer Druck der in Strömungsrichtung S vorgelagerten Probenflüssigkeit P) wieder starten. Ein entsprechendes strömungsmechanisches Verhalten der Probenflüssigkeit P' erfolgt auch bei den weiteren, in Strömungsrichtung S nachfolgenden Bereichen K bzw. Aufnahmeeinrichtungen 9 bis 11 bzw. 13 bis 15. Jeder der Aufnahmeeinrichtungen 8 bis 11 ist jeweils eine Entlüftungseinrichtung 100 zugeordnet, von denen nur die der Aufnahmeeinrichtung 10 Zugeordnete dargestellt ist.

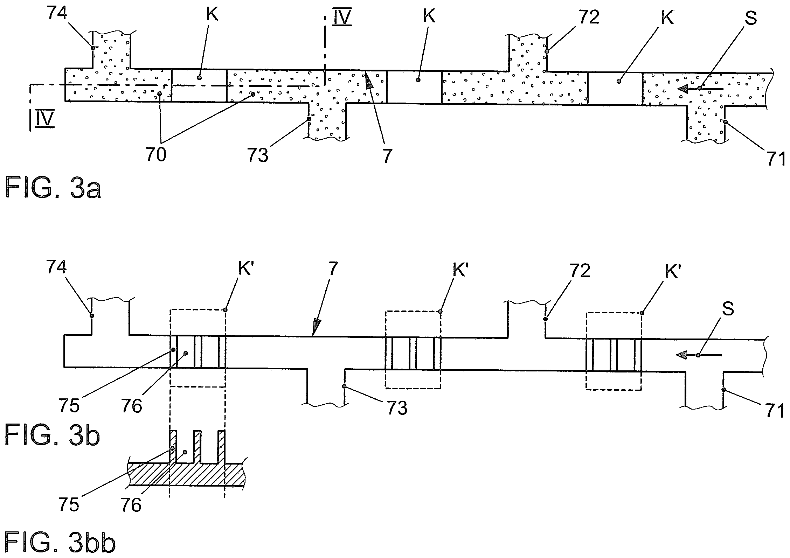

In Fig. 3 ist nun der Bereich des Verteilerkanals 7 mit dem zwischen den Zulaufkanälen 71 bis 74 jeweils eingebrachten Bereich K näher dargestellt. So zeigt die Fig. 3a eine bevorzugte Ausgestaltung der Bereiche K. Die Bereiche K sind dort nämlich hydrophob ausgestaltet im Vergleich zum Rest des Verteilerkanals 7, welcher mit einer hydrophilen Beschichtung 70 versehen ist. Wie gezeigt, reicht die hydrophile Beschichtung auch bis in die Zulaufkanäle 71 bis 74 und den entsprechenden Aufnahmebereichen 8 bis 11.

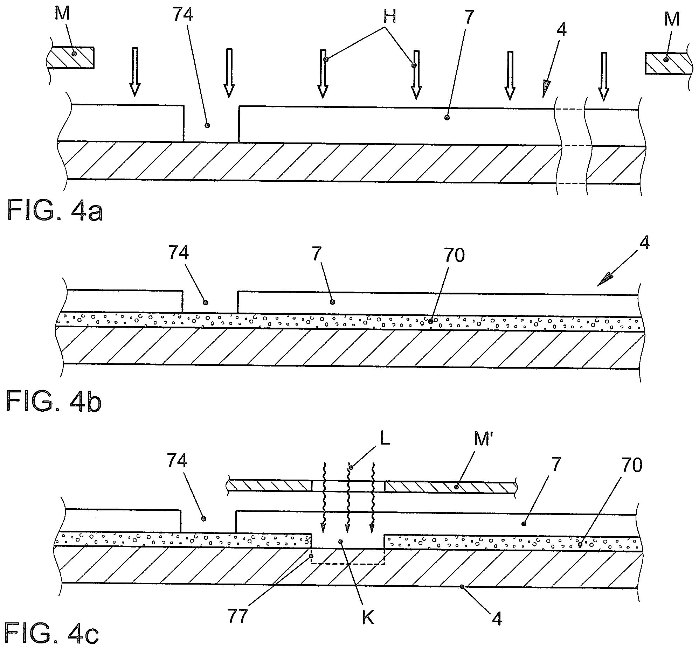

In der Fig. 3b bzw. bb ist eine alternative Ausgestaltung K' solcher Bereiche vorgesehen, bei der der gewünschte Effekt des zumindest temporären Stoppens bzw. Verzögern des kapillaren Flusses der Probenflüssigkeit P' allein durch geometrische Veränderung des Verteilerkanals 7 erfolgt. Konkret sind hierzu in den Bereichen K' in Strömungsrichtung S sich abwechselnde Bereiche von Querschnittsverengungen 75 und Querschnittserweiterungen 76 vorgesehen. Für die Erzeugung der erforderlichen scharfen Kanten im Abformteil ist jedoch eine aufwändige Bearbeitung des Formeinsatzes notwendig, wodurch eine wirtschaftliche Herstellung erst bei sehr hohen Stückzahlen ermöglicht wird. Insgesamt hat sich überdies in Versuchen gezeigt, dass mit dem erfindungsgemäßen Verfahren (vgl. Fig.4) eine bessere fluidische Wirkung erzielt werden kann.

In Fig. 4 ist nun das erfindungsgemäße Verfahren näher dargestellt, mit dem die gemäß Fig. 3a dargestellten, hydrophoben Bereiche K in den Verteilerkanal 7 eingebracht werden können. Der Verteilerkanal 7 hat dabei bevorzugt Abmessungen von etwa 150 bis 200 Mikrometern in der Breite sowie in der Höhe, die Zulaufkanäle 71 bis 74 sind in ihren Abmessungen geringfügig kleiner gewählt.

Zunächst wird das Bauteil 4 im Bereich des Verteilerkanals 7, der Zulaufkanäle 71 bis 74 und der Aufnahmebereiche 8 bis 11 mit einer hydrophilen Flüssigkeit H besprüht. Dies erfolgt großflächig und ist daher für eine entsprechende Massenfertigung gut geeignet. Gegebenenfalls kann eine Maske M eingesetzt werden (vergleiche Fig. 4a).

Die hydrophile Flüssigkeit H setzt sich als hydrophile Schicht 70 in dem nicht durch die Maske M abgedeckten Bereich nieder (vergleiche Fig. 4b).

Anschließend wird die hydrophile Schicht 70 mittels Laserstrahlen L bereichsweise wieder entfernt. Hierbei wird bevorzugt wiederum eine Maske M' eingesetzt. Als Laser hat sich der Einsatz eines Excimer-Lasers sehr bewährt. Dieser entwickelt im Bereich der auftreffenden Laserstrahlen L so große Energiedichten, dass eine gute Ablation der abzutragenden Werkstoffe möglich ist. Der Abtrag der abzutragenden Schichten kann sehr genau und ohne nennenswerte Verunreinigungen der Umgebung mit abgetragenem Material erfolgen. In der Fig. 4c ist ersichtlich, wie sich aufgrund der Bestrahlung des Bauteils 4 mit Laserstrahlung L im Verteilerkanal 7 des Bauteils 4 ein Bereich K ausgebildet hat. Durch die Entfernung der hydrophilen Schicht 70 im Bereich K wurde die Oberfläche des darunterliegenden Werkstoffs vom Bauteil 4, welches aus einem weniger hydrophilen Werkstoff besteht, als die Schicht 70. wieder freigelegt. Nicht der Laserstrahlung L ausgesetzte (maskierte) Bereiche werden nicht verändert. Es ist darauf hinzuweisen, dass der unter der abgetragenen hydrophilen Schicht 70 liegende Werkstoff nicht oder nur vernachlässigbar verändert wird, wenn der Werkstoff des Bauteils 4 ein Material ist, das für die Wellenlänge des verwendeten Lasers im Wesentlichen unempfindlich ist. Dies ist beispielsweise bei Polystyrol der Fall. Bei Verwendung eines für die Wellenlänge des verwendeten Lasers im Wesentlichen empfindlichen Werkstoffs (beispielsweise Polycarbonat) würde bei der Laserbearbeitung auch der unter der hydrophilen Schicht 70 liegende Werkstoff ablatiert und sich eine zusätzliche Querschnittserweiterung 77 (gestrichelt angedeutet) im Bauteil 4 ergeben. Aufgrund dieser zusätzlichen Querschnittserweiterung würde sich die gewünschte Wirkung des Bereichs K (Verlangsamen bzw. Stoppen des kapillaren Flusses) noch verstärken. Parameter, die dazu dienen können, die besagte Wirkung des Bereichs K nach Bedarf einzustellen, sind in erster Linie:
- Anzahl der auftreffenden Laserpulse pro bearbeiteter Stelle (Laserenergie)
- Position des bearbeiteten Bereichs zwischen jeweils zwei aufeinander folgenden Aufnahmeeinrichtungen in Strömungsrichtung gesehen (gegebenenfalls maskenabhängig)
- Wahl des unter der hydrophilen Schicht 70 befindlichen Werkstoffes.

Die Position eines solchen Bereichs K zum temporären Verlangsamen oder Stoppen des kapillaren Flusses in Strömungsrichtung gesehen wurde jeweils vorzugsweise innerhalb der ersten Hälfte des Abstandes, insbesondere innerhalb des ersten Drittels des Abstandes von direkt aufeinanderfolgenden Zulaufkanälen vorgesehen. Dies galt auch für die Position der Bereiche K' (in den Figuren ist diese bevorzugte Position jeweils nicht dargestellt).

### Bezugszeichenliste

- 1: Biosensor
- 2: erstes Bauteil
- 3: zweites Bauteil
- 4: drittes Bauteil
- 5: Filter
- 6: erste Aufnahmeeinrichtung vom dritten Bauteil 4
- 7: Verteilerkanal
- 8-11: weitere Aufnahmeeinrichtungen vom dritten Bauteil 4
- 12-15: Aufnahmeeinrichtungen vom zweiten Bauteil 3
- 17: Elektrodensystem
- 20: Öffnung zur Aufgabe der Probenflüssigkeit P
- 21: Vertiefung zur Aufnahme des Filters 5
- 40: Öffnung
- 70: hydrophile Beschichtung
- 71-74: vom Verteilerkanal 7 abzweigende Zulaufkanäle
- 75: Querschnittsverengung
- 76: Querschnittserweiterung
- 77: Querschnittserweiterung im dritten Bauteil 4
- 100: Entlüftungseinrichtung
- H: hydrophile Flüssigkeit
- K, K': eingebrachter Bereich zum zumindest zeitweisen Verlangsamen oder Stoppen des kapillaren Flusses der filtrierten Probenflüssigkeit P'
- L: Laserstrahlung
- M, M': Maske
- P: Probenflüssigkeit
- P': filtrierte Probenflüssigkeit
- S: Strömungsrichtung von P' im Verteilerkanal 7

## Patentansprüche

1. Verfahren zur Herstellung eines Bauteils (4) eines Biosensors, wobei das Bauteil (4) im Spritzgussverfahren aus Kunststoff hergestellt wird und ein Kanalsystem mit einem Verteilerkanal (7) aufweist, das eine erste Aufnahmeeinrichtung (6) mit weiteren napfartigen Aufnahmeeinrichtungen (8-11) verbindet,
**dadurch gekennzeichnet, dass** das Verfahren folgende Verfahrensschritte zur Herstellung eines Bereiches (K) zum zumindest zeitweisen Verlangsamen oder Stoppen des kapillaren Flusses einer Probenflüssigkeit (P') in dem Verteilerkanal (7) beinhaltet:
• Zumindest bereichsweise Hydrophilisierung des Kanals (7) mit einer hydrophilen Schicht (70) und
• bereichsweise Entfernung der hydrophilen Schicht (70) mittels eines gepulst betriebenen Lasers (L).

2. Verfahren nach Anspruch 1, **dadurch gekennzeichnet, dass** die hydrophile Schicht (70) aufgesprüht wird.

3. Verfahren nach Anspruch 2, **dadurch gekennzeichnet, dass** die hydrophile Schicht (70) unter Verwendung einer Maske (M) aufgesprüht wird.

4. Verfahren nach wenigstens einem der Ansprüche 1 bis 3, **dadurch gekennzeichnet, dass** die hydrophile Schicht (70) unter Verwendung einer Maske (M') entfernt wird.

5. Verfahren nach einem der Ansprüche 1-4, **dadurch gekennzeichnet, dass** die hydrophile Schicht (70) ablatiert wird.

6. Verfahren nach einem der Ansprüche 1 bis 5 , **dadurch gekennzeichnet, dass** der Verteilerkanal (7) aus einem Werkstoff gewählt ist, der für die Wellenlänge des verwendeten Lasers (L) empfindlich ist.

## Claims

1. Process for producing a component (4) of a biosensor, wherein the component (4) is produced by injection moulding of plastics and comprises a channel system with a distributor channel (7), the channel system connecting a first receiving device (6) to other well-like receiving devices (8 to 11),
**characterised in that**
the process comprises the following process steps for producing a region (K) for at least temporarily slowing down or stopping the capillary flow of a sample liquid (P') in the distributor channel (7):
• rendering the channel (7) hydrophilic with a hydrophilic coating (70), at least in parts, and
• removing the hydrophilic coating (70) in parts by using a laser (L) which is operated in pulses.

2. Process according to claim 1, **characterised in that** the hydrophilic coating (70) is sprayed on.

3. Process according to claim 2, **characterised in that** the hydrophilic coating (70) is sprayed on using a mask (M).

4. Process according to at least one of claims 1 to 3, **characterised in that** the hydrophilic coating (70) is removed using a mask (M').

5. Process according to one of claims 1-4, **characterised in that** the hydrophilic coating (70) is ablated.

6. Process according to one of claims 1 to 5, **characterised in that** the distributor channel (7) is chosen to be of a material that is sensitive to the wavelength of the laser (L) used.

## Revendications

1. Procédé de fabrication d'un composant (4) d'un biocapteur, dans lequel le composant (4) est fabriqué à partir de matière plastique lors du procédé de moulage par injection et présente un système de canal avec un canal de distribution (7), qui relie un premier dispositif de logement (6) à d'autres dispositifs de logement (8 - 11) de type cuvette,
**caractérisé en ce que** le procédé contient des étapes de procédé suivantes aux fins de la fabrication d'une zone (K) pour ralentir au moins temporairement ou arrêter le flux capillaire d'un échantillon liquide (P') dans le canal de distribution (7) ;
• l'hydrophilisation au moins par endroits du canal (7) avec une couche (70) hydrophile, et
• le retrait par endroits de la couche (70) hydrophile au moyen d'un laser (L) fonctionnant de manière pulsée.

2. Procédé selon la revendication 1, **caractérisé en ce que** la couche hydrophile (70) est appliquée par pulvérisation.

3. Procédé selon la revendication 2, **caractérisé en ce que** la couche hydrophile (70) est appliquée par pulvérisation en utilisant un masque (M).

4. Procédé selon au moins l'une quelconque des revendications 1 à 3, **caractérisé en ce que** la couche hydrophile (70) est retirée en utilisant un masque (M').

5. Procédé selon l'une quelconque des revendications 1 à 4, **caractérisé en ce que** la couche (70) hydrophile est détachée.

6. Procédé selon l'une quelconque des revendications 1 à 5, **caractérisé en ce que** le canal de distribution (7) est choisi parmi un matériau, qui est sensible à la longueur d'onde du laser (L) utilisé.
